(19) Europäisches Patentamt
European Patent Office
Office européen des brevets

(11) **EP 3 553 831 A1**

(12) **EUROPEAN PATENT APPLICATION**

(43) Date of publication:
**16.10.2019 Bulletin 2019/42**

(51) Int Cl.:
***H01L 31/048*** (2014.01)     ***H02S 20/23*** (2014.01)
***F24S 25/15*** (2018.01)

(21) Application number: **18186265.7**

(22) Date of filing: **30.07.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.04.2018   CN 201810327185
12.04.2018   CN 201820520854 U**

(71) Applicant: **Beijing Hanergy Solar Power Investment Co., Ltd.
101499 Beijing (CN)**

(72) Inventors:
• **Cheng, Xiaolong**
  **Beijing, Beijing 101499 (CN)**
• **Tong, Delin**
  **Beijing, Beijing 101499 (CN)**
• **Zhang, Liqin**
  **Beijing, Beijing 101499 (CN)**

(74) Representative: **Cohausz & Florack
Patent- & Rechtsanwälte
Partnerschaftsgesellschaft mbB
Bleichstraße 14
40211 Düsseldorf (DE)**

(54) **SOLAR CELL MODULE, PREPARATION METHOD AND VEHICLE**

(57)     The disclosure provides a solar cell module, a method for preparing the solar cell module, and a vehicle having the solar cell module. The solar cell module comprises an upper encapsulation layer (101) having a predefined curved surface shape, a solar cell array (102), an adhesive film (103), and at least one lower encapsulation back plate (104, 201-204, 205-209). A number of the lower encapsulation back plates (104, 201-204, 205-209) is determined according to a radius of curvature of the curved surface shape; and the solar cell array (102) is placed between the upper encapsulation layer (101) and the at least one lower encapsulation back plate (104, 201-204, 205-209) through the adhesive film (103) according to the curved surface shape, and a placement area of the at least one lower encapsulation back plate (104, 201-204, 205-209) is not greater than a surface area of the upper encapsulation layer (101). Therefore, the solar cell module can be placed on the curved surface having a small radius of curvature.

FIG. 1

**Description**

**CROSS-REFERENCE TO RELATED APPLICATIONS**

This application claims priority to Chinese Applications No. 201810327185.5 and No. 201820520854.6 filed on April 12, 2018 in the State Intellectual Property Office of China, the entire contents of which are incorporated herein by reference.

**FIELD OF THE INVENTION**

The present disclosure relates to the field of solar photovoltaic application technologies, and in particular, to a solar cell module, a method for preparing the solar cell module, and a vehicle having the solar cell module.

**BACKGROUND**

Since the solar cell module can supply electric power to a vehicle by using solar energy without consuming energy sources such as gasoline or diesel, it has been widely used in vehicles such as automobiles.

At present, in order to reduce the possibility of forming wrinkles or wavy patterns in a solar cell module, the solar cell module generally has a large range of radius of curvature. When the solar cell module is placed on a device (for example, a roof of a vehicle), the solar cell module can only be placed on a surface having a large radius of curvature of the device (for example, a surface having a radius of curvature of 1200 mm to 6000 mm). Therefore, the existing solar cell arrays are limited in placement and can only be placed on curved surfaces having a large radius of curvature.

**SUMMARY**

In view of above, the present disclosure proposes a solar cell module, a method for preparing the solar cell module, and a vehicle having the solar cell module. According to the present disclosure, the solar cell module can be placed on a curved surface having a small radius of curvature.

In a first aspect, an embodiment of the present disclosure provides a solar cell module including: a solar cell array, an adhesive film, an upper encapsulation layer having a predefined curved surface shape, and at least one lower encapsulation back plate, wherein a number of the lower encapsulation back plates is determined according to a radius of curvature of the curved surface shape; and the solar cell array is placed between the upper encapsulation layer and the at least one lower encapsulation back plate through the adhesive film according to the curved surface shape, and a placement area of the at least one lower encapsulation back plate is not greater than a surface area of the upper encapsulation layer.

In a second aspect, an embodiment of the present disclosure provides a method for preparing the solar cell module, including steps of: preparing (Step 301) a solar cell array, an adhesive film and an upper encapsulation layer having a predefined curved surface shape; preparing (Step 302) at least one lower encapsulation back plate, wherein a number of the at least one lower encapsulation back plate is determined according to a radius of curvature of the curved surface shape; and placing (Step 303) the solar cell array between the upper encapsulation layer and the at least one lower encapsulation back plate through the adhesive film according to the curved surface shape, wherein a placement area of the at least one lower encapsulation back panel is not greater than a surface area of the upper encapsulation layer.

In a third aspect, an embodiment of the present disclosure provides a vehicle including the above solar cell module, wherein an outer surface of a cover member of the vehicle is covered with the solar cell module.

The above description is only an overview of the technical solutions of the present disclosure. In order to more clearly understand the technical means of the disclosure and implement it in accordance with the disclosed description, and in order to more readily understand the above-described and other objectives, features and advantages of the present disclosure, specific embodiments of the present disclosure will be provided hereinafter.

**BRIEF DESCRIPTION OF THE DRAWINGS**

In order to more clearly illustrate the embodiments of the present disclosure or the technical solutions in the prior art, the drawings to be used in the embodiments or the description of the prior art will be briefly described below. Obviously, the drawings in the following description relate to some of embodiments of the present disclosure. Further drawings can be obtained from those drawings by an ordinary skill in the art without any inventive work.

FIG. 1 is a schematic structural diagram of a solar cell module according to an embodiment of the present disclosure;
FIG. 2 is a top plan view of the solar cell module according to the embodiment of the present disclosure;

FIG. 3 is a front elevational view of the solar cell module according to the embodiment of the present disclosure;

FIG. 4 is a top plan view of a solar cell module according to another embodiment of the present disclosure;

FIG. 5 is a front elevational view showing the solar cell module according to another embodiment of the present disclosure;

FIG. 6 is a schematic diagram showing a solar cell connected in series according to an embodiment of the present disclosure;

FIG. 7 is a schematic diagram showing a solar cell connected in parallel according to an embodiment of the present disclosure;

FIG. 8 is a schematic diagram showing a solar cell connected in a series-parallel hybrid manner according to an embodiment of the present disclosure;

FIG. 9 is a flow chart showing a preparation method of a solar cell module according to an embodiment of the present disclosure;

FIG. 10 is a schematic structural diagram of a vehicle according to an embodiment of the present disclosure;

FIG. 11 is a top plan view of a solar cell module according to still another embodiment of the present disclosure;

FIG. 12 is a front elevational view showing the solar cell module according to still another embodiment of the present disclosure; and

FIG. 13 is a left side view of the solar cell module according to still another embodiment of the present disclosure.

## DETAILED DESCRIPTION OF THE EMBODIMENTS

Exemplary embodiments of the present disclosure will be described further in detail below with reference to the accompanying drawings. Although the exemplary embodiments of the present disclosure are shown in the drawings, it should be understood that the present disclosure can be embodied in various forms and is not restricted by the embodiments as set forth herein. Rather, these embodiments are provided for more fully understanding the disclosure and for completely conveying the scope of the disclosure to those skilled in the art.

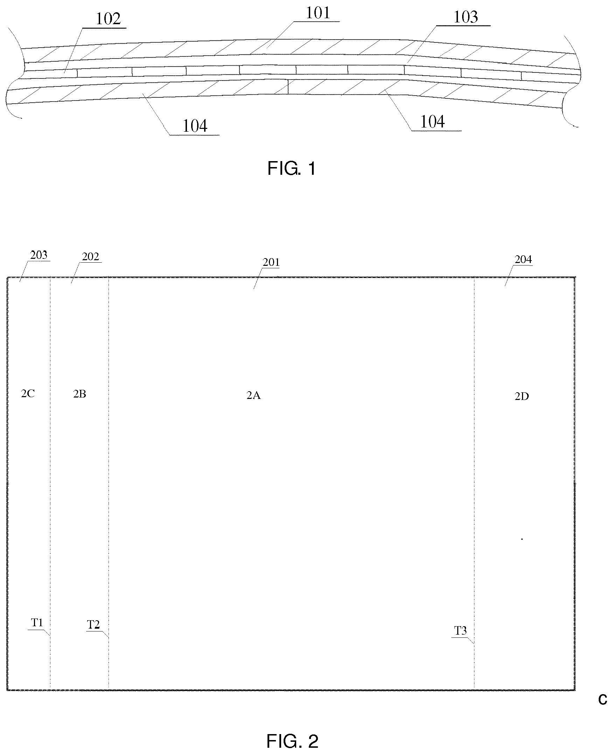

As shown in FIG. 1, an embodiment of the present disclosure provides a solar cell module including: a solar cell array 102, an adhesive film 103, an upper encapsulation layer 101 having a predefined curved surface shape, and at least one lower encapsulation back plate 104, wherein a number of the lower encapsulation back plates 104 is determined according to a radius of curvature of the curved surface shape; the solar cell array 102 is placed between the upper encapsulation layer 101 and the at least one lower encapsulation back plate 104 through the adhesive film 103 according to the curved surface shape; and a placement area of the at least one lower encapsulation back plate 104 is not greater than a surface area of the upper encapsulation layer 101.

According to the embodiment shown in FIG. 1, the solar cell module includes the solar cell array, the adhesive film, the upper encapsulation layer having the curved surface shape, and one or more lower encapsulation back plates. The number of lower encapsulation back plates is determined by the radius of curvature of the curved surface shape. The solar cell array is placed between the upper encapsulation layer and the lower encapsulation back plates through the adhesive film according to the curved surface shape, and the placement area of each of the lower encapsulation back plates is not greater than the surface area of the upper encapsulation layer. Here, the surface area may be a surface area of the upper encapsulation layer on a side that is in contact with the solar cell array. In other words, the placement area of the respective lower encapsulation back plates is equal to the surface area of the upper encapsulation layer, or the placement area of the respective lower encapsulation back plates is slightly smaller than the surface area of the upper encapsulation layer. According to the above embodiment, since the number of the lower encapsulation back plates is determined according to the radius of curvature of the curved surface shape, when the upper encapsulation layer has a small radius of curvature (for example, a minimum radius of curvature is 600 mm to 1200 mm), the lower encapsulation back plates can be placed on the upper encapsulation layer so that the solar cell module can be placed on a curved surface having a small radius of curvature (for example, a minimum radius of curvature is 600 mm to 1200 mm). Therefore, in this manner according to the embodiment of the present disclosure, it is possible to place the solar cell module on the curved surface having a small radius of curvature.

FIG. 1 schematically shows a partial solar cell module comprising two lower encapsulation back plates.

In one embodiment of the present disclosure, a curved surface shape of the upper encapsulation layer corresponds to a curved surface shape of an object to be placed. For example, when the object to be placed is a roof of the vehicle, the curved surface shape of the upper encapsulation layer of the solar cell module is consistent with the curved surface shape of the roof so as to have a higher degree of fitness between the solar cell module and the roof.

In this embodiment, preferably, the upper encapsulation layer has a minimum radius of curvature greater than or equal to 600 mm.

In an embodiment of the present disclosure, a relationship between the number of the lower encapsulation back plates 104 and the radius of curvature of the curved surface shape satisfies: the number of the lower encapsulation back plates 104 decreases as the minimum radius of curvature of the curved surface shape increases.

In this embodiment, the smaller the minimum radius of curvature of the curved surface shape, the larger the curvature of the curved surface. When the curvature of the curved surface is relatively large, the number of the lower encapsulation back plates need to be increased. In this way, the curvature variation on a single lower encapsulation back plate can be reduced during the placement, thereby reducing the possibility of forming wrinkles or wavy patterns on the lower encapsulation back plates.

In an embodiment of the present disclosure, when determining the number of lower encapsulation back plates according to the minimum radius of curvature of the curved surface shape, the relationship between the number of the lower encapsulation back plates 104 and the radius of curvature of the curved surface shape includes at least the following two situations:

As to the first situation, in an embodiment of the present disclosure, the relationship between the number of the lower encapsulation back plates 104 and the radius of curvature of the curved surface shape satisfies an equation group (1);

$$\begin{cases} N = 1 & R_{\min} \geq 2000 \\ N = 2 & 1500 \leq R_{\min} < 2000 \\ N = 3 & 1000 \leq R_{\min} < 1500 \\ N = 4 & 800 \leq R_{\min} < 1000 \\ N = 5 & 600 \leq R_{\min} < 800 \end{cases} \qquad (1)$$

wherein, N represents the number of the lower encapsulation back plates; and $R_{\min}$ represents the minimum radius of curvature of the curved surface shape with a unit of mm.

In this embodiment, the curved surface having a small radius of curvature is usually a curved surface having a large curvature. When placing a larger lower encapsulation back plate on a curved surface having a larger curvature, the lower encapsulation back plate usually forms wrinkles or wavy patterns. These wrinkles or wavy patterns often easily result in bubbles or empty drums in the solar cell module, and the bubbles or empty drums will reduce the reliability and safety of the solar cell module.

In this embodiment, in order to reduce the possibility of forming wrinkles or wavy patterns on the lower encapsulation back plate, it is necessary to obtain radiuses of curvature of curved surfaces included in the upper encapsulation layer, and then compare the radiuses of curvature of curved surfaces to find a minimum radius of curvature in curved surfaces. Then, based on the scale of the minimum radius of curvature, the number of lower encapsulation back plates is determined. It can be seen from the equation group (1) that the equation (1) is suitable for the case where the minimum radius of curvature is greater than or equal to 600 mm. When the minimum radius of curvature is greater than or equal to 600 mm, the number of lower encapsulation back plates can be determined directly according to the equation (1).

In this embodiment, when the radius of curvature is greater than or equal to 600 mm, the larger the minimum radius of curvature, the less the number of lower encapsulation back plates.

For example, if it is determined that the minimum radius of curvature of the curved surface shape is 750 mm, the number of lower encapsulation back plates is determined to be five according to the equation group (1).

As to the second situation, in an embodiment of the present disclosure, the relationship between the number of the lower encapsulation back plates 104 and the radius of curvature of the curved surface shape satisfies an equation group (2),

$$\begin{cases} N = 1 & R_{\min} \geq 2000 \\ N = 2 \sim 4 & 800 \leq R_{\min} < 2000 \\ N = 5 & 600 \leq R_{\min} < 800 \end{cases} \qquad (2)$$

wherein, N represents the number of the lower encapsulation back plates; and $R_{\min}$ represents the minimum radius of curvature of the curved surface shape, with a unit of mm.

In this embodiment, when the minimum radius of curvature is within a range of 800 mm to 2000 mm, two to four lower encapsulation back plates can be selected as required. For example, two lower encapsulation back plates, three lower encapsulation back plates, or four lower encapsulation back plates can be selected.

Specifically, when the minimum radius of curvature is within the range of 800 mm to 2000 mm, if it is desired to reduce splice points between the lower encapsulation back plates, the number of the lower encapsulation back plates can be determined to be two. When it is desired to minimize the possibility of forming wrinkles or wavy patterns on the lower encapsulation back plates, the number of lower encapsulation back plates can be determined to be four.

According to the above embodiment, when the minimum radius of curvature is greater than or equal to 600 mm, the number of lower encapsulation back plates can be determined according to the minimum radius of curvature. Therefore, in the case where the minimum radius of curvature is greater than or equal to 600 mm, the placement of the lower encapsulation back plates with a number matching the minimum radius of curvature can reduce the possibility of forming wrinkles or wavy patterns, thereby improving the reliability and safety of the solar cells.

In one embodiment of the present disclosure, the number of the lower encapsulation back plates 104 is determined according to a minimum radius of curvature and a maximum radius of curvature of the curved surface shape.

In this embodiment, the greater the difference between the maximum radius of curvature and the minimum radius of curvature in the curved surface shape, the greater the curvature or fluctuation of the curved surface shape. Therefore, the number of lower encapsulation back plates can be determined according to the minimum radius of curvature and the maximum radius of curvature in the curved surface shape to narrow the corresponding range of curvature variation of each lower encapsulation back plate during the placement.

In an embodiment of the present disclosure, the relationship between the number of the lower encapsulation back plates 104 and the radius of curvature of the curved surface shape satisfies an equation (3),

$$N = \left\lceil K \times \frac{R_{\max}}{R_{\min}} \right\rceil \qquad (3)$$

wherein, N represents the number of the lower encapsulation back plates; $R_{\max}$ represents the maximum radius of curvature of the curved surface shape; $R_{\min}$ represents the minimum radius of curvature of the curved surface shape; K represents a preset quantity constant; and $\lceil \ \rceil$ represents an up-round symbol.

In this embodiment, the greater the difference between the maximum radius of curvature and the minimum radius of curvature in the curved surface shape, the greater the curvature or fluctuation of the curved surface shape. Therefore, the number of lower encapsulation back plates can be determined by a multiple relationship between the maximum radius of curvature and the minimum radius of curvature. The lower curved back plate having a relatively small area is placed on a curved surface having a relatively large curvature, thereby reducing the possibility of forming wrinkles or wavy patterns of the lower encapsulation back plate during the placement.

In this embodiment, the quantity constant K can be determined according to business requirements. For example, the quantity constant K can be any constant greater than zero. In addition, the quantity constant K can be determined according to the material, modulus of elasticity, and deformation coefficient of the lower encapsulation back plate.

According to the above embodiment, since the number of the lower encapsulation back plates is determined according to the minimum radius of curvature and the maximum radius of curvature in the curved surface shape, the lower encapsulation back plate having a relatively small area can be placed on the curved surface having a large curvature, thereby reducing the possibility of forming wrinkles or wavy patterns of the lower encapsulation back plate during the placement.

In one embodiment of the present disclosure, at least two lower encapsulation back plates 104 are provided and the lower encapsulation back plates 104 each have the same or different areas.

In one embodiment of the present disclosure, when the lower encapsulation back plates 104 each have the same area, the area of the lower encapsulation back plate can be determined by determining a placeable area in a placeable region. In this manner, a quotient between the placeable area and the number of lower encapsulation back plates is then determined as an area of a single lower encapsulation back plate. Herein, the placeable area may be a surface area of the upper encapsulation layer on the side in contact with the solar cell array.

In this embodiment, since the lower encapsulation back plates each have the same area, the lower encapsulation back plates may each have the same length and width.

According to the above embodiment, the lower encapsulation back plates each have the same area, so that the lower encapsulation back plates can be mass-produced to improve the production efficiency of the lower encapsulation back plates.

In an embodiment of the present disclosure, the lower encapsulation back plates 104 each have a different area. A region of the curved surface shape of the upper encapsulation layer 101 having a larger radius of curvature corresponds to a lower encapsulation back plate 104 having a larger area, and a region of the curved surface shape of the upper encapsulation layer 101 having a smaller radius of curvature corresponds to a lower encapsulation back plate 104 having a smaller area.

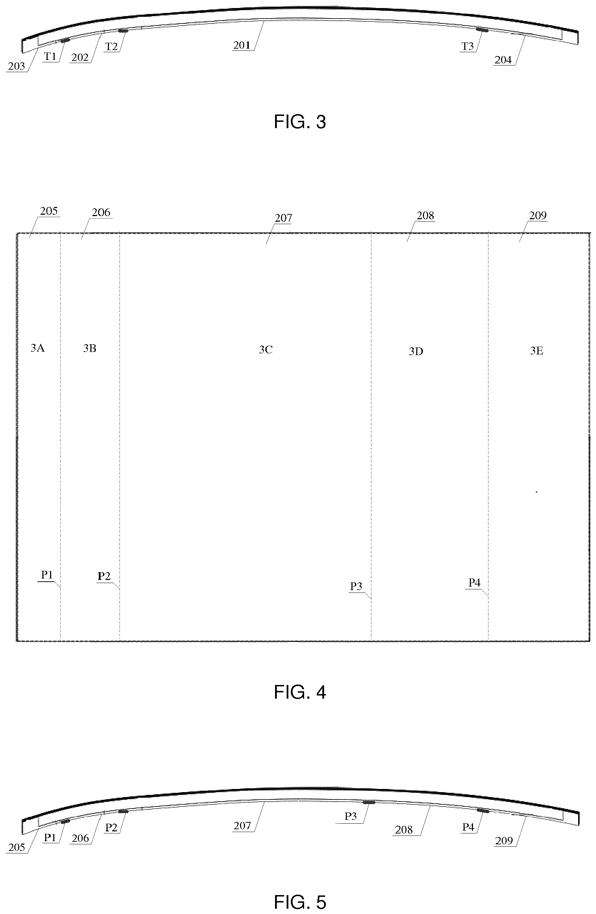

Hereinafter, a minimum radius of curvature of 900 mm will be described as an example. In this embodiment, since the minimum radius of curvature of 900 mm is between 800 mm and 1000 mm, four lower encapsulation back plates can be designed according to the equation group (1), namely: a lower encapsulation back plate 201, a lower encapsulation back plate 202, a lower encapsulation back plate 203 and a lower encapsulation back plate 204, as shown in FIGS. 2 and 3. In the figures, T1 is an overlapping region of the lower encapsulation back plate 203 and the lower encapsulation back plate 202, T2 is an overlapping region of the lower encapsulation back plate 202 and the lower encapsulation back plate 201, and T3 is an overlapping region of the lower encapsulation back plate 201 and the lower encapsulation back plate 204. The lower encapsulation back plate 201 is placed in a region 2A, and the region 2A corresponds to "a radius of curvature greater than 5000 mm". The lower encapsulation back plate 204 is placed in a region 2D, and the region 2D corresponds to "a radius of curvature less than 5000 mm and greater than 3000 mm". The lower encapsulation back plate 202 is placed in a region 2B, and the region 2B corresponds to "a radius of curvature less than 3000 mm and greater than 2000 mm". The lower encapsulation back plate 203 is placed in a region 2C, and the region 2C corresponds to "a radius of curvature less than 2000 mm". According to the radiuses of curvature corresponding to the lower encapsulation back plates, an area relationship among the lower encapsulation back plates 201-204 can be determined as: lower encapsulation back plate 201 > lower encapsulation back plate 204 > lower encapsulation back plate 202 > lower encapsulation back plate 203.

Hereinafter, a minimum radius of curvature of 620 mm will be described as an example. In this embodiment, since the minimum radius of curvature 620 mm is between 600 mm and 800 mm, five lower encapsulation back plates can be designed according to the equation group (1), namely: a lower encapsulation back plate 205, a lower encapsulation back plate 206, a lower encapsulation back plate 207, a lower encapsulation back plate 208 and the lower encapsulation back plate 209, as shown in FIGS. 4 and 5. In the figures, P1 is an overlapping region of the lower encapsulation back plate 205 and the lower encapsulation back plate 206, P2 is an overlapping region of the lower encapsulation back plate 206 and the lower encapsulation back plate 207, P3 is an overlapping region of the lower encapsulation back plate 207 and the lower encapsulation back plate 208, and P4 is an overlap region of the lower encapsulation back plate 208 and the lower encapsulation back plate 209. The lower encapsulation back plate 207 is placed in a region 3C, and the region 3C corresponds to "a radius of curvature greater than 6000 mm". The lower encapsulation back plate 208 is placed in a region 3D, and the region 3D corresponds to "a radius of curvature less than 6000 mm and greater than 3000 mm". The lower encapsulation back plate 209 is placed in a region 3E, and the region 3E corresponds to "a radius of curvature greater than 2000 mm and less than 3000 mm". The lower encapsulation back plate 206 is placed in a region 3B, and the region 3B corresponds to "a radius of curvature less than 2000 mm and greater than 800 mm". The lower encapsulation back plate 205 is placed in a region 3A, and the region 3A corresponds to "a radius of curvature less than 800 mm". According to the radiuses of curvature of the lower encapsulation back plates, an area relationship among the lower encapsulation back plates 205-209 can be determined as: lower encapsulation back plate 207 > lower encapsulation back plate 208 > lower encapsulation back plate 209 > lower encapsulation back plate 206 > lower encapsulation back plate 205.

According to the above embodiment, the lower encapsulation back plates each have a different area. A region of the curved surface shape of the upper encapsulation layer having a larger curvature corresponds to a lower encapsulation back plate having a larger area, and a region of the curved surface shape of the upper encapsulation layer having a smaller curvature corresponds to a lower encapsulation back plate having a smaller area. Therefore, the possibility of forming wrinkles or wavy patterns can be more effectively reduced to improve the reliability of the solar cell.

In one embodiment of the present disclosure, when at least two lower encapsulation back plates 104 are provided, an overlapping region of 5 mm to 30 mm is formed between any adjacent two lower encapsulation back plates 104.

In this embodiment, a width of the overlapping region may be any value between 5 mm and 30 mm. For example, the overlapping region may have a width of 8 mm or 10 mm.

In this embodiment, the width of the overlapping region cannot be excessively narrow or excessively wide. If the width of the overlapping region is excessively narrow, there is a high possibility that the solar cell array is exposed to an outside, and if the width of the overlapping region is excessively wide, a great amount of waste of the lower encapsulation back plates would occur.

According to the above embodiment, it is preferable that there is an overlapping region of 5 mm to 30 mm between any two adjacent lower encapsulation back plates. This overlapping region not only can lower the possibility of exposure of the solar cell array, but also can reduce the amount of waste of the lower encapsulation back plate.

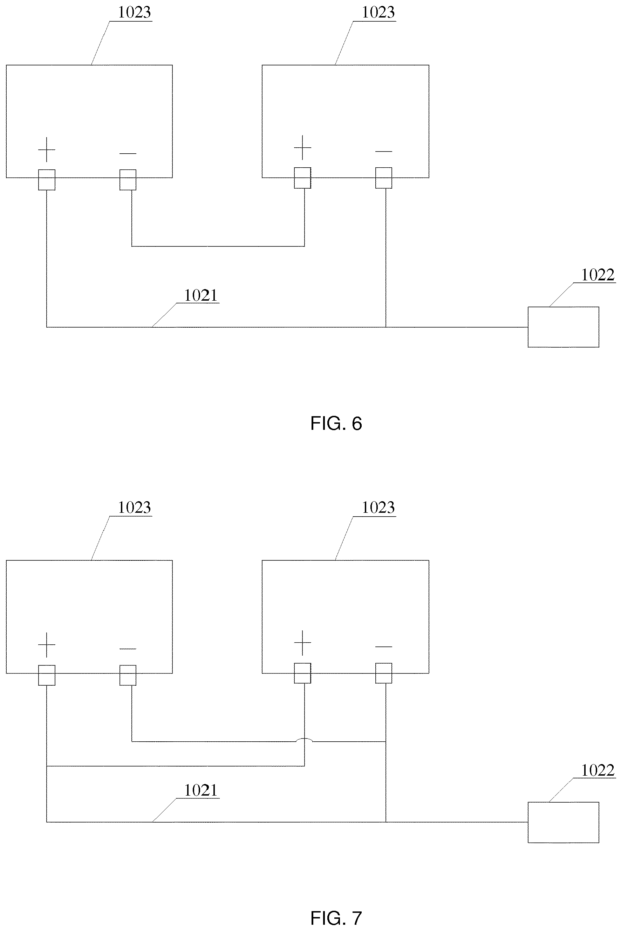

In an embodiment of the present disclosure, as shown in FIGS. 6-8, the solar cell array 102 may include a bus bar 1021, an output end 1022, and a plurality of solar cells 1023.

The plurality of solar cells 1023 are connected into a current output group in any one of a series connection, a parallel connection, or a series-parallel hybrid connection.

The current output group is connected to the bus bar 1021 for transmitting a current generated by the current output group itself to the bus bar 1021.

The bus bar 1021 is configured to transmit the current from the current output group to the output end 1022.

The output end 1022 is connected to an external power storage device for transmitting the current from the bus bar 1021 to the power storage device.

In this embodiment, the type of solar cell can be determined according to business requirements. For example, materials of the solar cell may include, but is not limited to, copper indium gallium selenide thin film, perovskite thin film, organic semiconductor thin film , and gallium arsenide (GaAs) compound semiconductor thin film.

In this embodiment, the type and location of the output end can be determined according to business requirements. For example, when the output end is disposed on a side edge of the solar cell module, the output end may be a segment of an output line which may be connected to a power storage device (such as an accumulator battery in a vehicle). As another example, when the output end is disposed on a lower surface of any of the lower encapsulation back plates that is not in contact with the adhesive film, the output end can be a junction box which may be connected to a power storage device (such as an accumulator battery in a vehicle).

In this embodiment, the plurality of solar cells are connected into a current output group and the current output group has a placement area as the same as that of the lower encapsulation back plates. As an alternative, the current output group has a placement area slightly smaller than that of lower encapsulation back plates. Since the number of the lower encapsulation back plates is determined according to the radius of curvature of the curved surface shape, the placeable area of the lower encapsulation back plate is relatively large, and the placement area of the current output group is enlarged, thereby increasing the output power of the solar cell module.

According to the above embodiment, the plurality of solar cells are connected into the current output group in any one of the series connection, the parallel connection, or the series-parallel hybrid connection, business applications are more flexible.

In an embodiment of the present disclosure, the plurality of solar cells 1023 are connected in series into the current output group; in the solar cells 1023 connected in series, a positive electrode of the first solar cell 1023 is connected to the bus bar 1021, and the negative electrode of the last solar cell 1023 is connected to the bus bar 1021.

For the sake of clarity, only two solar cells connected in series are shown in FIG. 6. In this embodiment, as shown in FIG. 6, the positive electrode of the first solar cell 1023 is connected to the bus bar 1021, and the negative electrode of the last solar cell 1023 is connected to the bus bar 1021. Of any two adjacent solar cells, the positive electrode of one solar cell is connected to the negative electrode of the other solar cell.

In an embodiment of the present disclosure, the plurality of solar cells 1023 are connected in parallel into the current output group; in the solar cells 1023 connected in parallel, a positive electrode of each of the solar cells 1023 is connected to the bus bar 1021, and a negative electrode of each of the solar cells is connected to the bus bar 1021.

For the sake of clarity, only two solar cells connected in parallel are shown in FIG. 7. In this embodiment, as shown in FIG. 7, the positive electrode of each of the solar cells is connected to the bus bar, and the negative electrode of each of the solar cells is connected to the bus bar.

In an embodiment of the present disclosure, the plurality of solar cells 1023 are connected in a series-parallel hybrid connection into the current output group; the plurality of solar cells 1023 form at least two cell strings, wherein each of the cell strings includes at least two solar cells 1023 connected in series; a positive electrode of the first solar cell 1023 in each of the cell strings is connected to the bus bar 1022, and a negative electrode of the last solar cell 1023 is connected to the bus bar 1022 such that the at least two cell strings are connected in parallel.

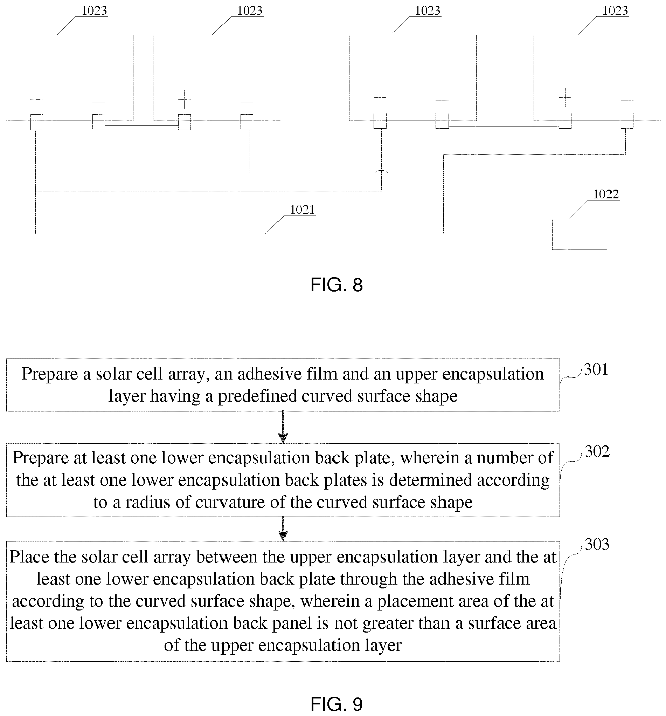

For the sake of clarity, only two cell strings are shown in FIG. 8 and each cell string comprises two solar cells connected in series. In this embodiment, as shown in FIG. 8, the positive electrode of the first solar cell in each of the cell strings is connected to the bus bar, and the negative electrode of the last solar cell is connected to the bus bar. Of any two adjacent solar cells in each of the cell strings, the positive electrode of one solar cell is connected to the negative electrode of the other solar cell such that the two cell strings are connected in parallel.

According to the above embodiment, the plurality of solar cells are connected in series-parallel hybrid connection into the current output group. Since the solar cells are connected in series-parallel hybrid connection, even if some of the solar cells of the solar cell module are obstructed in use, the solar cells which are not obstructed can be stably outputted.

In an embodiment of the present disclosure, a pre-set interval is formed between any two adjacent solar cells 1023, wherein the interval is 0 to 5 mm.

In this embodiment, the interval can be determined according to the business requirements. For example, in the case of a limited space, in order to arrange more solar cells, the interval can be set to zero. When the space is sufficient, the interval can be set to 2 mm taking into account of the deformation of the solar cell module in application.

According to the above embodiment, any two adjacent solar cells have an interval of 0 to 5 mm. Therefore, the solar cells can be arranged according to different spatial conditions, and thus an enhanced service suitability can be provided.

In an embodiment of the present disclosure, the solar cell module may further include a sealing tape configured to be attached on the upper encapsulation layer and form a placement region with the upper encapsulation layer.

The solar cell array and the at least one lower encapsulation back plate are adhesively placed in the placement area.

In this embodiment, the specific type of sealing tape can be determined according to business requirements. For example, materials of the sealing tape may include, but is not limited to, modified polyvinyl chloride, neoprene, thermoplastic EPDM, and vulcanized EPDM.

In this embodiment, when attached to the upper encapsulation layer, the sealing tape can be attached to a peripheral edge of the upper encapsulation layer.

According to the above embodiment, since the solar cell array and the respective lower encapsulation back plates are adhesively placed in the placement region defined by the sealing tape and the upper encapsulation layer, in use of the solar cell module, the possibility that the solar cell array is eroded by moisture or the like can be reduced, thereby improving the reliability of the solar cell module.

In an embodiment of the present disclosure, materials of the upper encapsulation layer may include, but is not limited to, common glass, tempered glass, laminated glass, polystyrene, polymethyl methacrylate, polycarbonate, polyethylene terephthalate, and ethylene-tetrafluoroethylene copolymer.

In this embodiment, an upper encapsulation layer having a visible light transmittance of 91% or more and having effects of moisture-proof and impact-resistance can also be selected.

In this embodiment, a thickness of the upper encapsulation layer may be 0.5 mm to 8 mm.

In one embodiment of the present disclosure, materials of the lower encapsulation back plate may include, but is not limited to, inorganic glass, stainless steel, ethylene/vinyl alcohol copolymer, polyethylene glycol terephthalate, and composites of polyethylene glycol terephthalate and aluminium.

In this embodiment, the lower encapsulation back plate has an excellent flexibleness so as to correspondingly bend according to the variation in curvature of the upper encapsulation layer, so that the lower encapsulation back plate can be perfectly attached to the upper encapsulation layer.

In this embodiment, a thickness of the lower encapsulation back plate may be 0.2 mm to 5 mm.

In an embodiment of the present disclosure, materials of the adhesive film may include, but is not limited to, polyolefin, polyvinyl butyral, ethylene-vinyl acetate copolymer, and organic silicone.

In this embodiment, a thickness of the adhesive film between the upper encapsulation layer and the solar cell array and a thickness of the adhesive film between the lower encapsulation back plate and the solar cell array may both be 0.1 mm to 1.5 mm.

In an embodiment of the disclosure, when the solar cell module is applicable to a vehicle, the curved surface shape of the upper encapsulation layer 101 coincides with a curved surface shape of any of cover members in the vehicle.

In this embodiment, the cover member includes but is not limited to an engine cover, a roof cover, left and right side panels, front and rear doors, front, rear, left and right fenders, trunk cover, engine front support board, engine front apron, front wall upper cover, rear wall, rear upper cover, front apron, front frame, front fender, wheel fender, rear fender, rear panel, luggage cover, rear upper cover, top roof, front side panel, front panel, front upper cover, front samller fender, and engine hood.

In this embodiment, in order to allow the solar module to receive sufficient irradiation of sunlight, the solar module is preferably covered on a roof of the vehicle. When the solar module needs to be covered on the roof of the vehicle, the curved surface shape of the upper encapsulation layer coincides with the curved surface shape of the roof of the vehicle.

As shown in FIG. 9, an embodiment of the present disclosure provides a method for preparing a solar cell module, comprising steps of:

Step 301: preparing a solar cell array, an adhesive film and an upper encapsulation layer having a predefined curved surface shape;

Step 302: preparing at least one lower encapsulation back plate, wherein a number of the at least one lower encapsulation back plates is determined according to a radius of curvature of the curved surface shape; and

Step 303: placing the solar cell array between the upper encapsulation layer and the at least one lower encapsulation back plate through the adhesive film according to the curved surface shape, wherein a placement area of the at least one lower encapsulation back panel is not greater than a surface area of the upper encapsulation layer.

According to the flow chart shown in Fig. 9, the solar cell array, the adhesive film, and the upper encapsulation layer having a curved surface are first prepared. One or more lower encapsulation back plates are then prepared, and the number of lower encapsulation back plates is determined according to the radius of curvature of the curved surface shape. Then, the solar cell array is placed between the upper encapsulation layer and the lower encapsulation back plates through the adhesive film according to the curved surface shape, and the placement area of the lower encapsulation back plates is not greater than the surface area of the upper encapsulation layer. According to the above embodiment, the number of the lower encapsulation back plates is determined according to the radius of curvature of the curved surface shape. Therefore, when the radius of curvature of the upper encapsulation layer has a small radius of curvature (for example, a minimum radius of curvature is 600 mm to 1200 mm), the lower encapsulation back plates can be placed on the upper encapsulation layer so that the solar cell module can be placed on a curved surface having a small radius of curvature (for example, a minimum radius of curvature is 600 mm to 1200 mm). Therefore, in this manner according to the embodiment of the present disclosure, it is possible to place the solar cell module on the curved surface having a small radius of curvature.

In an embodiment of the present disclosure, in the flowchart shown in FIG. 9, the Step 302 of preparing at least one lower encapsulation back plate, wherein a number of the at least one lower encapsulation back plates is determined according to a radius of curvature of the curved surface shape, may include:

A1: determining a minimum radius of curvature of the curved surface shape;
A2: determining the number of the lower encapsulation back plates according to the minimum radius of curvature, wherein the number of the lower encapsulation back plates decreases as the minimum radius of curvature of the curved surface shape increases; and
A3: preparing the lower encapsulation back plates according to the determined number of the lower encapsulation back plates.

In an embodiment of the present disclosure, the step A2 can be implemented in the following two manners:

Manner 1: In an embodiment of the present disclosure, the step A2 of determining the number of the lower encapsulation back plates according to the minimum radius of curvature includes:
calculating the number of the lower encapsulation back plates by using an equation group (1) according to the radius of curvature of the curved surface shape;

$$\begin{cases} N = 1 & R_{min} \geq 2000 \\ N = 2 & 1500 \leq R_{min} < 2000 \\ N = 3 & 1000 \leq R_{min} < 1500 \\ N = 4 & 800 \leq R_{min} < 1000 \\ N = 5 & 600 \leq R_{min} < 800 \end{cases} \qquad (1)$$

wherein, N represents the number of the lower encapsulation back plates; and $R_{min}$ represents the minimum radius of curvature of the curved surface shape with a unit of mm.
Manner 2: In an embodiment of the present disclosure, the step A2 of determining the number of the lower encapsulation back plates according to the minimum radius of curvature includes:
calculating the number of the lower encapsulation back plates by using an equation group (2) according to the radius of curvature of the curved surface shape;

$$\begin{cases} N = 1 & R_{min} \geq 2000 \\ N = 2\sim4 & 800 \leq R_{min} < 2000 \\ N = 5 & 600 \leq R_{min} < 800 \end{cases} \qquad (2)$$

wherein, N represents the number of the lower encapsulation back plates; and $R_{min}$ represents the minimum radius of curvature of the curved surface shape, with a unit of mm.

In an embodiment of the present disclosure, in the above-mentioned flowchart of FIG. 9, the Step 302 of preparing at least one lower encapsulation back plate, wherein a number of the at least one lower encapsulation back plate is determined according to a radius of curvature of the curved surface shape, may include:

determining the number of the lower encapsulation back plates according to a minimum radius of curvature and a maximum radius of curvature of the curved surface shape; and
preparing the lower encapsulation back plates according to the determined number of the lower encapsulation back plates.

In an embodiment of the present disclosure, the step of determining the number of the lower encapsulation back plates according to the minimum radius of curvature and the maximum radius of curvature of the curved surface shape includes:
calculating the number of the lower encapsulation back plates by using an equation (3) according to the radius of curvature of the curved surface shape,

$$N = \left\lceil K \times \frac{R_{max}}{R_{min}} \right\rceil \qquad (3)$$

wherein, N represents the number of the lower encapsulation back plates; $R_{max}$ represents the maximum radius of curvature of the curved surface shape; $R_{min}$ represents the minimum radius of curvature of the curved surface shape; K represents a preset quantity constant; and Γ ⌉ represents an up-round symbol.

In an embodiment of the present disclosure, when the solar cell module includes at least two lower encapsulation back plates, the prepared lower encapsulation back plates each have the same or different areas.

In an embodiment of the present disclosure, when the lower encapsulation back plates each have different areas, a region of the curved surface shape of the upper encapsulation layer having a larger radius of curvature corresponds to a lower encapsulation back plate having a larger area, and a region of the curved surface shape of the upper encapsulation layer having a smaller radius of curvature corresponds to a lower encapsulation back plate 104 having a smaller area.

In an embodiment of the present disclosure, after the Step 303 of placing the solar cell array between the upper encapsulation layer and the at least one lower encapsulation back plate through the adhesive film according to the curved surface shape in the flow chart shown in FIG. 9, the method may further include:

B1: vacuuming the solar cell array, the upper encapsulation layer, and the at least one lower encapsulation back plate to form a module to be prepared; and

B2: laminating the module to be prepared to form a solar cell module.

In an embodiment of the present disclosure, the step B1 of vacuuming the solar cell array, the upper encapsulation layer, and the at least one lower encapsulation back plate may include:

placing the solar cell array, the upper encapsulation layer, and the at least one lower encapsulation back plate in a vacuum bag; and

performing, by a vacuuming device, a vacuuming operation on the vacuum bag, wherein the vacuuming operation is performed for 0.5 to 1 hour, such that a vacuum degree in the vacuum bag after the vacuuming operation is -80 KPa to -100 KPa, wherein the vacuum degree is a relative vacuum degree.

In this embodiment, the module to be prepared may be entirely placed in the vacuum bag of a vacuum laminating machine, and a vacuum is applied at room temperature, wherein the vacuum operation is performed for 0.5 to 1 hour, such that a vacuum degree in the vacuum bag after the vacuuming operation is -80 KPa to -100 KPa. During the vacuuming operation, the air between the upper encapsulation layer and the lower encapsulation back plate can be extracted.

According to the above embodiment, since the vacuum bag is vacuumed by the vacuuming device, the air between the upper encapsulation layer and the lower encapsulation back plate is discharged, such that the occurrence of air bubbles or empty drums in the solar cell module can be lowered.

In an embodiment of the present disclosure, the step B2 of laminating the module to be prepared to form a solar cell module may include:

laminating, by a laminating machine, the module to be prepared after the vacuuming process for 1 to 3 hours under a working condition of a temperature of 130 °C to 160 °C and a vacuum degree of -80 KPa to -100 KPa, wherein the vacuum degree is a relative vacuum degree.

In this embodiment, the laminating machine laminates the module to be prepared after the vacuuming process for 1 to 3 hours under the operating conditions of the temperature of 130 °C to 160 °C and the vacuum degree of -80 KPa to -100 KPa. The adhesive film can be fully melted and crosslinked to be filled into gaps between the upper encapsulation layer, the solar cell array, the adhesive film, and the respective lower encapsulation back plates.

In an embodiment of the present disclosure, the Step 303 of placing the solar cell array between the upper encapsulation layer and the at least one lower encapsulation back plate through the adhesive film according to the curved surface shape in the flow chart shown in FIG. 9 may include:

placing the solar cell array on a lower surface of the upper encapsulation layer through the adhesive film according to the curved surface shape, and sequentially splicing the at least two lower encapsulation back plates according to the curved surface shape to place on a lower surface of the solar cell array through the adhesive film to form a module to be prepared.

In this embodiment, when the lower encapsulation back plates are sequentially spliced according to the curved surface shape and placed on the lower surface of the solar cell array through the adhesive film, an overlapping region of 5 mm-30 mm may be formed between any two of adjacent lower encapsulation back plates.

In this embodiment, prior to the steps of placing the solar cell array on a lower surface of the upper encapsulation layer through the adhesive film according to the curved surface shape, and sequentially splicing the at least two lower encapsulation back plates according to the curved surface shape to place on a lower surface of the solar cell array through the adhesive film, the method may further include: attaching a sealing tape on the upper encapsulation layer, and forming a placement region with the upper encapsulation layer; and placing the solar cell array and the respective lower encapsulation back plates in the placement region.

In this embodiment, materials of the sealing tape may include, but is not limited to, any one of modified polyvinyl chloride, neoprene, thermoplastic EPDM, and vulcanized EPDM.

In an embodiment of the present disclosure, the Step 301 of preparing the upper encapsulation layer having the predefined curved surface shape, the solar cell array, and the adhesive film in the flow chart shown in FIG. 9 may include:

preparing a bus bar, an output end, and a plurality of solar cells;
connecting the plurality of solar cells into a current output group in any one of a series connection, a parallel connection, or a series-parallel hybrid connection;
connecting the current output group to the bus bar; and
connecting the current output group to an external power storage device.

In this embodiment, a pre-set interval is formed between any two adjacent solar cells, wherein the interval is 0 to 5 mm.

In this embodiment, materials of the solar cell may include, but is not limited to, copper indium gallium selenide thin film, perovskite thin film, organic semiconductor thin film and gallium arsenide (GaAs) compound semiconductor thin film.

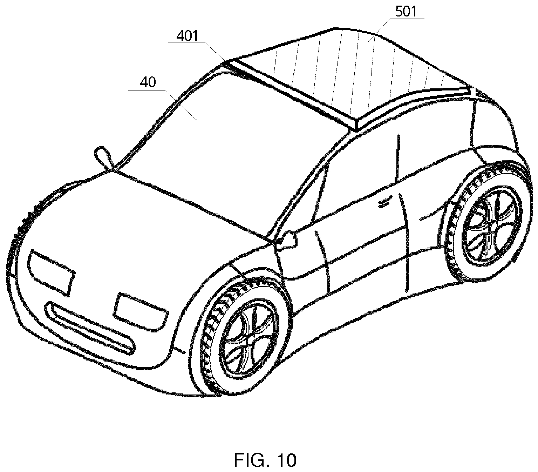

As shown in FIG. 10, an embodiment of the present disclosure provides a vehicle, comprising: the solar cell module 501 according to any of the above embodiments, wherein an outer surface of a cover member of the vehicle is covered with the solar cell module 501.

In this embodiment, as shown in FIG. 10, a roof 401 of a vehicle 40 is covered with the solar cell module 501 (the solar cell module 501 is shown in the shaded portion in the figure).

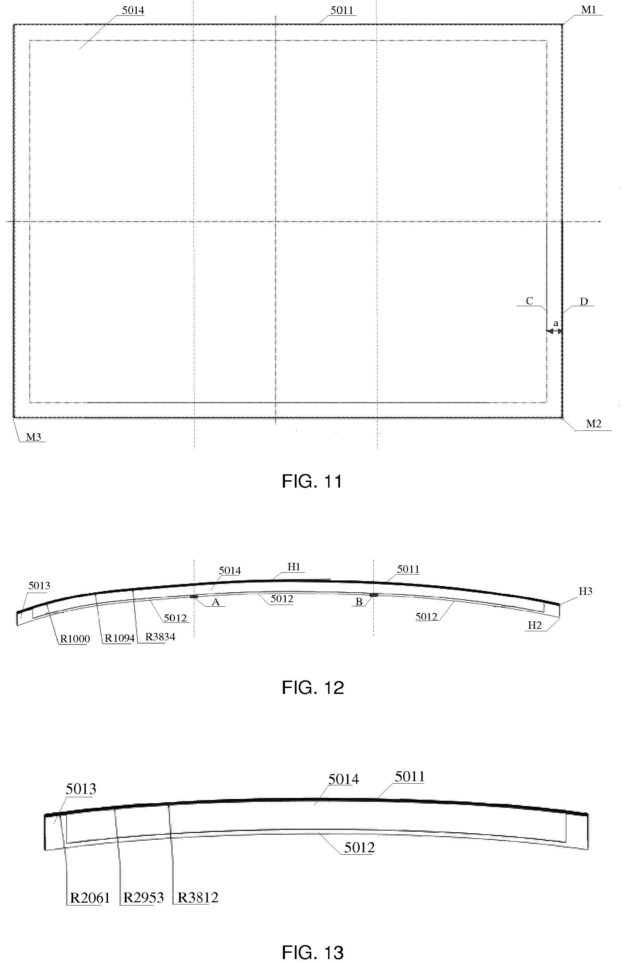

In this embodiment, a curved surface shape of the solar cell module shown in FIG. 10 coincides with a curved surface shape of the roof of the vehicle. According to the radiuses of curvature included in the curved surface, a minimum radius of curvature in the curved surface shape is determined to be 1000 mm. For example, radiuses of curvature of R1000, R1094, R3834, R2061, R2935, R3812 and respective regions corresponding to the radiuses of curvature in the curved surface shape are shown in FIGS. 12 and 13. Therefore, according to the equation group (1), three lower encapsulation back plates are provided for the solar cell module, and a total placement area of the three lower encapsulation back plates is equal to an inner surface area of the upper encapsulation layer.

Hereinafter, a solar cell module covering the roof of the vehicle will be described with reference to Figs. 11 to 13. The solar cell module includes an upper encapsulation layer 5011, three lower encapsulation back plates 5012, an adhesive film 5013, and a solar cell array 5014. The points A and B indicated by the short thick lines in Fig. 12 are the splicing portions between the adjacent encapsulation back plates.

Specifically, FIG. 11 is a top plan view of the solar cell module. As can be seen from FIG. 11, a centre of the placed solar cell array coincides with a centre of the upper encapsulation layer, and an edge C of the solar cell array has a distance a from an edge D of the upper encapsulation layer. This distance a can be determined according to business requirements. For example, the distance a is 40mm (it should be noted that 40 mm is provided only as an example). It can also be seen from FIG. 11 that a width of a projection plane corresponding to the solar cell module (that is, a horizontal distance between a point M1 and a point M2 in FIG. 11) can be determined according to the curved surface shape of the roof of the vehicle. For example, the horizontal distance between the point M1 and the point M2 is 1017 mm, and a length of the projection plane corresponding to the solar cell module (that is, a horizontal distance between the point M2 and a point M3 in FIG. 11) may be determined according to the curved surface shape of the roof of the vehicle. For example, the horizontal distance between the point M2 and the point M3 is 1395 mm. (It should be noted that 1017mm and 1395 mm are provided only as one example).

Specifically, FIG. 12 is a front view of the solar cell module. As can be seen from Fig. 12, a height between a highest point and a lowest point of the curved surface of the solar cell module (i.e., a vertical distance between a point H1 and a point H2 in Fig. 12) can be determined according to the curved surface shape of the roof of the vehicle. For example, the vertical distance between the point H1 and the point H2 can be 111mm (it should be noted that 111mm is provided only as an example). A height between a highest point and a lowest point of a curved surface of the upper encapsulation layer (that is, a vertical distance between the point H1 and a point H3 in Fig. 12) can be determined according to the curved surface shape of the roof of the vehicle. For example, the vertical distance between the point H1 and the point H3 can be 79 mm (it should be noted that 79mm is provided only as an example).

Specifically, FIG. 13 is a left side view of the solar cell module.

The embodiments of the present disclosure have at least the following beneficial effects.

In the embodiments of the present disclosure, the solar cell module includes the solar cell array, the adhesive film, the upper encapsulation layer having the curved surface shape, and one or more lower encapsulation back plates.

The number of lower encapsulation back plates is determined according to the radius of curvature of the curved surface shape. The solar cell array is placed between the upper encapsulation layer and the lower encapsulation back plates through the adhesive film according to the curved surface shape, and the placement area of the lower encapsulation back plate is not greater than the surface area of the upper encapsulation layer. The surface area may be a surface area on the side of the upper encapsulation layer that is in contact with the solar cell array. For example, the placement area of the lower encapsulation back plates is equal to the surface area of the upper encapsulation layer, or the placement area of the lower encapsulation back plates is slightly smaller than the surface area of the upper encapsulation layer. According to the above embodiments, the number of the lower encapsulation back plates is determined according to the radius of curvature of the curved surface shape. Therefore, when the radius of curvature of the upper encapsulation layer is small (for example, the minimum radius of curvature is 600 mm to 1200 mm), the respective lower encapsulation back plates can be placed on the upper encapsulation layer such that the solar cell module can be placed on the curved surface having a small radius of curvature (for example, the minimum radius of curvature is 600 mm to 1200 mm). Therefore, the solution according to the embodiments of the present disclosure can realize that the solar cell module is able to be placed on a curved surface having a small radius of curvature.

In the embodiment of the present disclosure, the number of the lower encapsulation back plates can be reduced as the minimum radius of curvature of the curved surface shape increases, such that the curvature variation on a single lower encapsulation back plate can be reduced, thereby reducing the possibility of forming wrinkles or wavy patterns on the lower encapsulation back plates.

In the embodiments of the present disclosure, since the number of the lower encapsulation back plates is determined according to the minimum radius of curvature of the curved surface shape, the possibility of forming wrinkles or wavy patterns can be reduced when placing the respective lower encapsulation back plates, thereby improving the reliability and safety of solar cells.

In the embodiments of the present disclosure, when the minimum radius of curvature is greater than or equal to 600 mm, the number of lower encapsulation back plates may be determined according to the minimum radius of curvature. Therefore, when the minimum radius of curvature is greater than or equal to 600 mm, the placement of the lower encapsulation back plates with a number matching the minimum radius of curvature can reduce the possibility of forming wrinkles or wavy pattern, thereby improving the reliability and safety of the solar cells.

In the embodiment of the present disclosure, the number of lower encapsulation back plates is determined according to the minimum radius of curvature and the maximum radius of curvature of the curved surface shape. Therefore, it is possible to place the lower encapsulation back plate having a relatively small area in a curved surface having a large curvature, thereby reducing the possibility of forming wrinkles or wavy patterns during the placement of the lower encapsulation back plate.

In the embodiments of the present disclosure, the lower encapsulation back plates each have the same area, such that the lower encapsulation back plates can be mass-produced to improve the production efficiency of the lower encapsulation back plates.

In the embodiments of the present disclosure, the lower encapsulation back plates each have a different area. A region of the curved surface shape of the upper encapsulation layer having a larger radius of curvature corresponds to a lower encapsulation back plate having a larger area, and a region of the curved surface shape of the upper encapsulation layer having a smaller radius of curvature corresponds to a lower encapsulation back plate having a smaller area. Therefore, the possibility of forming wrinkles or wavy patterns can be more effectively reduced, thereby improving the reliability of the solar cell.

In the embodiments of the present disclosure, there is an overlapping region of 5 mm to 30 mm between any adjacent two lower encapsulation back plates. The overlapping region not only can reduce the possibility of exposure of the solar cell array, but also can reduce the wasted amount of the lower encapsulation back plates.

In the embodiments of the present disclosure, the plurality of solar cells are connected into a current output group in any one of the series connection, the parallel connection, or the series-parallel hybrid connection. Therefore, business applications can be more flexible.

In the embodiments of the present disclosure, the plurality of solar cells are connected in the series-parallel hybrid connection into a current output group. Since the solar cells are connected in series-parallel hybrid connection, even if some of the solar cells of the solar cell module are obstructed in use, the solar cells which are not obstructed can be stably outputted.

In the embodiments of the present disclosure, the pre-set interval of 0 to 5 mm is formed between any two adjacent solar cells. Therefore, the solar cells can be arranged according to different spatial conditions, and the service suitability can be enhanced.

In the embodiments of the present disclosure, since the solar cell array and the lower encapsulation back plates are adhesively placed in the placement region defined by the sealing tape and the upper encapsulating layer, in use of the solar cell module, the possibility that the solar cell array is eroded by moisture or the like can be reduced, thereby improving the reliability of the solar cell module.

In the embodiments of the present disclosure, since the vacuum bag is vacuumed by the vacuuming device, the air between the upper encapsulation layer and the lower encapsulation back plate is discharged, such that the occurrence of air bubbles or empty drums in the solar cell module can be lowered.

In the above embodiments, the focuses of the various embodiments are different, and the parts that are not described in detail in a certain embodiment can be referred to the related descriptions of other embodiments.

It should be noted that, in this context, relational terms such as first and second are merely provided to distinguish one entity or operation from another entity or operation, without necessarily requiring or implying actual relationships or sequences between these entities or operations. Furthermore, the term "include" or "comprise" or any other variants thereof is intended to encompass a non-exclusive inclusion, such that a process, method, article, or device that comprises a plurality of elements includes not only those elements but also other elements that are not definitely listed herein, or inherent elements to such a process, method, item, or device. Unless otherwise specified, an element that is defined by the phrase "comprising a" does not exclude the use of the same element in the process, method, article, or device that comprises the element.

In the end, it should be noted that the preferred embodiments of the present disclosure described above are only used to explain the technical solutions of the present disclosure, but not intended to limit the scope of the disclosure..

**Claims**

1. A solar cell module, comprising a solar cell array (102), an adhesive film (103), an upper encapsulation layer (101) having a predefined curved surface shape, and at least one lower encapsulation back plate (104, 201-204, 205-209), wherein
a number of the lower encapsulation back plates (104, 201-204, 205-209) is determined according to a radius of curvature of the curved surface shape; and
the solar cell array (102) is placed between the upper encapsulation layer (101) and the at least one lower encapsulation back plate (104, 201-204, 205-209) through the adhesive film (103) according to the curved surface shape, and a placement area of the at least one lower encapsulation back plate (104, 201-204, 205-209) is not greater than a surface area of the upper encapsulation layer (101).

2. The solar cell module according to claim 1, wherein
a relationship between the number of the lower encapsulation back plates (104, 201-204, 205-209) and the radius of curvature of the curved surface shape satisfies: the number of the lower encapsulation back plates (104, 201-204, 205-209) decreases as a minimum radius of curvature of the curved surface shape increases.

3. The solar cell module according to claim 2, wherein
the relationship between the number of the lower encapsulation back plates (104, 201-204, 205-209) and the radius of curvature of the curved surface shape satisfies an equation group (1):

$$\begin{cases} N = 1 & R_{\min} \geq 2000 \\ N = 2 & 1500 \leq R_{\min} < 2000 \\ N = 3 & 1000 \leq R_{\min} < 1500 \\ N = 4 & 800 \leq R_{\min} < 1000 \\ N = 5 & 600 \leq R_{\min} < 800 \end{cases}$$

wherein, N represents the number of the lower encapsulation back plates (104, 201-204, 205-209); and $R_{\min}$ represents the minimum radius of curvature of the curved surface shape with a unit of mm.

4. The solar cell module according to claim 2, wherein
the relationship between the number of the lower encapsulation back plates (104, 201-204, 205-209) and the radius of curvature of the curved surface shape satisfies an equation group (2):

$$\begin{cases} N = 1 & R_{\min} \geq 2000 \\ N = 2\sim 4 & 800 \leq R_{\min} < 2000 \\ N = 5 & 600 \leq R_{\min} < 800 \end{cases}$$

wherein, N represents the number of the lower encapsulation back plates (104, 201-204, 205-209); and $R_{min}$ represents the minimum radius of curvature of the curved surface shape, with a unit of mm.

5. The solar cell module according to claim 1 wherein
the number of the lower encapsulation back plates (104, 201-204, 205-209) is determined according to the minimum radius of curvature and a maximum radius of curvature of the curved surface shape.

6. The solar cell module according to claim 5, wherein
the relationship between the number of the lower encapsulation back plates (104, 201-204, 205-209) and the radius of curvature of the curved surface shape satisfies an equation (3):

$$N = \left\lceil K \times \frac{R_{max}}{R_{min}} \right\rceil$$

wherein, N represents the number of the lower encapsulation back plates (104, 201-204, 205-209); $R_{max}$ represents the maximum radius of curvature of the curved surface shape; $R_{min}$ represents the minimum radius of curvature of the curved surface shape; K represents a preset quantity constant; and ⌈ ⌉ represents an up-round symbol.

7. The solar cell module according to any one of claims 1 to 6, wherein
the solar cell module comprises at least two lower encapsulation back plates (104, 201-204, 205-209), and the lower encapsulation back plates (104, 201-204, 205-209) each have the same or different areas respectively;
and / or,
the solar cell module comprises at least two lower encapsulation back plates (104, 201-204, 205-209), and an overlapping region of 5 mm to 30 mm is formed between any two adjacent lower encapsulation back plates (104, 201-204, 205-209).

8. The solar cell module according to claim 1 wherein
the solar cell array (102) comprises a bus bar (1021), an output end (1022), and a plurality of solar cells (1023);
the plurality of solar cells (1023) are connected into a current output group in any one of a series connection, a parallel connection, or a series-parallel hybrid connection;
the current output group is connected to the bus bar (1021) for transmitting a current generated by the current output group itself to the bus bar (1021);
the bus bar (1021) is configured to transmit the current from the current output group to the output terminal; and
the output end (1022) is connected to an external power storage device for transmitting the current from the bus bar (1021) to the power storage device.

9. The solar cell module according to any one of claims 1 to 6 and 8, further comprising: a sealing tape configured to bed attached on the upper encapsulation layer (101) and forming a placement region with the upper encapsulation layer (101), wherein
the solar cell array (102) and the at least one lower encapsulation back plate (104, 201-204, 205-209) are placed in the placement region.

10. A method for preparing the solar cell module according to any one of claims 1 to 9, comprising the steps of:

preparing (Step 301) a solar cell array (102), an adhesive film (103) and an upper encapsulation layer (101) having a predefined curved surface shape;
preparing (Step 302) at least one lower encapsulation back plate (104, 201-204, 205-209), wherein a number of the at least one lower encapsulation back plate (104, 201-204, 205-209) is determined according to a radius of curvature of the curved surface shape; and
placing (Step 303) the solar cell array (102) between the upper encapsulation layer (101) and the at least one lower encapsulation back plate (104, 201-204, 205-209) through the adhesive film (103) according to the curved surface shape, wherein a placement area of the at least one lower encapsulation back panel is not greater than a surface area of the upper encapsulation layer (101).

11. The method according to claim 10, wherein the step of preparing (Step 302) at least one lower encapsulation back plate (104, 201-204, 205-209) wherein a number of the at least one lower encapsulation back plate (104, 201-204, 205-209) is determined according to a radius of curvature of the curved surface shape, comprises:

determining (A1) a minimum radius of curvature of the curved surface shape;
determining (A2) the number of the lower encapsulation back plates (104, 201-204, 205-209) according to the minimum radius of curvature, wherein the number of the lower encapsulation back plates (104, 201-204, 205-209) decreases as the minimum radius of curvature of the curved surface shape increases; and
preparing (A3) the lower encapsulation back plate (104, 201-204, 205-209) according to the determined number of the lower encapsulation back plates (104, 201-204, 205-209).

**12.** The method according to claim 11, wherein the step of determining (A2) the number of the lower encapsulation back plates (104, 201-204, 205-209) according to the minimum radius of curvature comprises:
calculating the number of the lower encapsulation back plates (104, 201-204, 205-209) by using an equation group (1) according to the radius of curvature of the curved surface shape, and the equation group (1) includes:

$$\begin{cases} N = 1 & R_{min} \geq 2000 \\ N = 2 & 1500 \leq R_{min} < 2000 \\ N = 3 & 1000 \leq R_{min} < 1500 \\ N = 4 & 800 \leq R_{min} < 1000 \\ N = 5 & 600 \leq R_{min} < 800 \end{cases}$$

wherein, N represents the number of the lower encapsulation back plates (104, 201-204, 205-209); and $R_{min}$ represents the minimum radius of curvature of the curved surface shape with a unit of mm.

**13.** The method according to claim 11, wherein the step of determining (A2) the number of the lower encapsulation back plates (104, 201-204, 205-209) according to the minimum radius of curvature comprises:
calculating the number of the lower encapsulation back plates (104, 201-204, 205-209) by using an equation group (2) according to the radius of curvature of the curved surface shape, and the equation group (2) includes:

$$\begin{cases} N = 1 & R_{min} \geq 2000 \\ N = 2\sim4 & 800 \leq R_{min} < 2000 \\ N = 5 & 600 \leq R_{min} < 800 \end{cases}$$

wherein, N represents the number of the lower encapsulation back plates (104, 201-204, 205-209); and $R_{min}$ represents the minimum radius of curvature of the curved surface shape, with a unit of mm.

**14.** The method according to claim 10, wherein the step of preparing (Step 302) at least one lower encapsulation back plate (104, 201-204, 205-209) wherein a number of the at least one lower encapsulation back plate (104, 201-204, 205-209) is determined according to a radius of curvature of the curved surface shape, comprises:

determining the number of the lower encapsulation back plates (104, 201-204, 205-209) according to a minimum radius of curvature and a maximum radius of curvature of the curved surface shape; and
preparing the lower encapsulation back plates (104, 201-204, 205-209) according to the determined number of the lower encapsulation back plates (104, 201-204, 205-209).

**15.** The method according to claim 14, wherein the step of determining the number of the lower encapsulation back plates (104, 201-204, 205-209) according to a minimum radius of curvature and a maximum radius of curvature of the curved surface shape, comprises:
calculating the number of the lower encapsulation back plates (104, 201-204, 205-209) by using an equation (3) according to the radius of curvature of the curved surface shape, and the equation (3) includes:

$$N = \left\lceil K \times \frac{R_{max}}{R_{min}} \right\rceil$$

wherein, N represents the number of the lower encapsulation back plates (104, 201-204, 205-209); $R_{max}$ represents the maximum radius of curvature of the curved surface shape; $R_{min}$ represents the minimum radius of curvature of the curved surface shape; K represents a preset quantity constant; and ⌈ ⌉ represents an up-round symbol.

102          101          103

104          104

FIG. 1

203    202          201                    204

2C    2B          2A              2D

T1    T2          T3

C

FIG. 2

FIG. 3

FIG. 4

FIG. 5

1023

1023

+ — + —

1021

1022

FIG. 6

1023

1023

+ — + —

1021

1022

FIG. 7

1023             1023             1023             1023

1022

1021

## FIG. 8

| 301 | Prepare a solar cell array, an adhesive film and an upper encapsulation layer having a predefined curved surface shape |
| 302 | Prepare at least one lower encapsulation back plate, wherein a number of the at least one lower encapsulation back plates is determined according to a radius of curvature of the curved surface shape |
| 303 | Place the solar cell array between the upper encapsulation layer and the at least one lower encapsulation back plate through the adhesive film according to the curved surface shape, wherein a placement area of the at least one lower encapsulation back panel is not greater than a surface area of the upper encapsulation layer |

## FIG. 9

FIG. 10

FIG. 11

FIG. 12

FIG. 13

Europäisches
Patentamt

European
Patent Office

Office européen
des brevets

# EUROPEAN SEARCH REPORT

Application Number

EP 18 18 6265

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2005 317714 A (NAKAJIMA GLASS CO INC) 10 November 2005 (2005-11-10) * abstract; figures 1-2 * * paragraphs [0003], [0016], [0020], [0023] - [0033], [0041], [0052] * ----- | 1-8, 10-15 | INV. H01L31/048 H02S20/23 F24S25/15 |
| X | JP H01 196181 A (NIPPON SHEET GLASS CO LTD) 7 August 1989 (1989-08-07) * the whole document * ----- | 1-15 | |
| X | CN 104 037 254 B (UNIV SUN YAT SEN) 25 January 2017 (2017-01-25) * paragraphs [0009] - [0016], [0035] - [0041]; figures 1-4 * ----- | 1-15 | |

TECHNICAL FIELDS
SEARCHED        (IPC)

H01L
H02S
F24S

The present search report has been drawn up for all claims

| Place of search | Date of completion of the search | Examiner |
|---|---|---|
| Berlin | 12 February 2019 | Cichos, Anna |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 18 18 6265

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2019

| Patent document cited in search report | | Publication date | Patent family member(s) | | Publication date |
|---|---|---|---|---|---|
| JP 2005317714 | A | 10-11-2005 | NONE | | |
| JP H01196181 | A | 07-08-1989 | JP | 2589529 B2 | 12-03-1997 |
| | | | JP | H01196181 A | 07-08-1989 |
| CN 104037254 | B | 25-01-2017 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201810327185

- CN 201820520854